# EUROPEAN PATENT APPLICATION

(11) **EP 4 290 577 A1**
(43) Date of publication of application: **13.12.2023**
(21) Application number: 22767371.2
(22) Date of filing: 23.02.2022
(51) Int. Cl.: H01L 27/32, G06F 1/16, H04N 5/225, H01L 51/52, H04M 1/02

(54) **ELECTRONIC APPARATUS COMPRISING DISPLAY**

(30) Priority: 10.03.2021 KR 20210031260
(71) Applicant: Samsung Electronics Co., Ltd., Suwon-si, Gyeonggi-do 16677 (KR)
(72) Inventor: LEE, Jaesung, Suwon-si, Gyeonggi-do 16677 (KR); KIM, Seungryeol, Suwon-si, Gyeonggi-do 16677 (KR); BAE, Jongkon, Suwon-si, Gyeonggi-do 16677 (KR); CHOI, Seungyeop, Suwon-si, Gyeonggi-do 16677 (KR); KIM, Kyungtae, Suwon-si, Gyeonggi-do 16677 (KR); KIM, Kwangtai, Suwon-si, Gyeonggi-do 16677 (KR); YEOM, Donghyun, Suwon-si, Gyeonggi-do 16677 (KR)
(74) Representative: HGF
(86) International application number: PCT/KR2022/002656
(87) International publication number: WO 2022/191475

(57) **Abstract**

According to various embodiments, an electronic apparatus comprises: a display comprising a display panel; and a camera module arranged under the display, wherein the display panel comprises: a substrate; a plurality of first pixels arranged in a first area of the substrate having first arrangement density; a plurality of second pixels arranged in a second area, other than the first area, having a second arrangement density greater than the first arrangement density; light-emitting units arranged at positions corresponding to the pixels; an optical waveguide layer arranged above the pixels; and a light extraction unit arranged on the optical waveguide layer in a first sub-area at least partially overlapping the space between the plurality of first pixels, and the light generated from the light-emitting unit is diffused into the first sub-area through the optical waveguide layer and may be emitted to the outside through the light extraction unit.

## Description

### [Technical Field]

Various embodiments of the disclosure relate to an electronic device including a display.

### [Background Art]

Electronic devices, for example, portable electronic devices are available in various sizes according to functions thereof and user preferences, and may include a large-screen touch display in order to secure a wide range of visibility and to guarantee convenient manipulation. An electronic device may include, as an optical module, at least one camera module disposed under the display in the inner space thereof. The at least one camera module may be disposed to photograph an external subject through at least a part of the display. Therefore, there may be a need for an improved display structure for efficient driving of the at least one camera module.

### [Disclosure of Invention]

### [Technical Problem]

An electronic device may include a display which is visible from the outside through at least a part of a cover member (for example, a front plate, a window, or a front cover). The area of the display may be gradually expanded such that the same is visible through substantially the entire area of the cover member (for example, front cover), in an attempt to satisfy the demand for large screens. In line with the expanding area of the display, the structure in which various electronic components (for example, at least one camera module) are disposed through the cover member may be changed accordingly. For example, if a camera module is disposed in an area (for example, a black matrix (BM) area or an inactive area) other than the display area of the cover member, expansion of the display area may be limited.

In order to solve such a problem, the camera module may include a disposition structure in which the same is disposed under the display (under display camera (UDC) structure), and the display panel may be formed to have a transmittance which enables the camera module to operate by lowering the density of disposition of pixels and/or electric wires in the area corresponding to the camera module.

However, such a UDC structure may degrade the reliability of the device and inconvenience the user because, in the display panel area corresponding to the camera module, the light-transmitting area between pixels having a relatively low density causes the corresponding UDC area to be recognized as a visually different area (block area) from the peripheral display area.

Various embodiments of the disclosure may provide an electronic device including a display, wherein visual recognition regarding a display panel area corresponding to a camera module is reduced, thereby helping improve the reliability of the device.

Various embodiments may provide an electronic device including a display configured to reduce the screen door effect (SDE) of the display when seen from the outside.

### [Solution to Problem]

According to various embodiments, an electronic apparatus may include a housing, a display disposed to be visible from the outside in an inner space of the housing and including a display panel, and a camera module disposed below the display, wherein the display panel may include a substrate, first multiple pixels arranged to have a first arrangement density in a first area of the substrate, which is overlapped with an effective aperture of the camera module, when the display is seen from above, second multiple pixels arranged to overlap a second area other than the first area of the substrate and have a second arrangement density higher than the first arrangement density, when the display is seen from above, a light-emitting part disposed at a position corresponding to the first multiple pixels and the second multiple pixels, an optical waveguide layer disposed above the first multiple pixels and the second multiple pixels, and a light extraction part disposed on the optical waveguide layer, in at least a part of a first sub-area of the first area, which is at least partially overlapped with the space between the first multiple pixels, when the display is seen from above, and wherein at least a part of the light generated from the light-emitting part may be diffused to the first sub-area through the optical waveguide layer and be emitted to the outside through the light extraction part.

According to various embodiments, a display panel may include a substrate, first multiple pixels arranged to have a first arrangement density in a first area of the substrate, second multiple pixels arranged to overlap a second area other than the first area of the substrate and have a second arrangement density higher than the first arrangement density, when the display is seen from above, a light-emitting part disposed at a position corresponding to the first multiple pixels and the second multiple pixels, an optical waveguide layer disposed above the first multiple pixels and the second multiple pixels, and a light extraction part disposed on the optical waveguide layer, in at least a part of a first sub-area of the first area, which is at least partially overlapped with the space between the first multiple pixels, when the display is seen from above, wherein at least a part of the light generated from the light-emitting part may be diffused to the first sub-area through the optical waveguide layer and be emitted to the outside through the light extraction part.

### [Advantageous Effects of invention]

A display of an electronic device according to exemplary embodiments of the disclosure includes a light guiding structure in which light emitted from a light-emitting portion is at least partially guided to be discharged to the outside through a transmissive area which does not overlap pixels in an area corresponding to a camera module such that the visibility of a display area corresponding to a camera module, from the outside, is reduced, thereby helping improve the reliability of the device.

Various other advantageous effects identified explicitly or implicitly through the disclosure may be provided.

### [Brief Description of Drawings]

In connection with the description of the drawings, the same or similar reference numerals will be used to refer to the same or similar elements.
FIG. 1 is a first front perspective view of an electronic apparatus according to various embodiments of the disclosure.
FIG. 2 is a rear perspective view of the electronic apparatus in FIG. 1 according to various embodiments of the disclosure.
FIG. 3 is an exploded perspective view of the electronic apparatus in FIG. 1 according to various embodiments of the disclosure.
FIG. 4 is an exploded perspective view of a display according to various embodiments of the disclosure.
FIG. 5 is a partial cross-sectional view of the electronic apparatus seen from line 5-5 in FIG. 1 according to various embodiments of the disclosure.
FIG. 6 is a partial enlarged cross-sectional view of an area 6 of the electronic apparatus in FIG. 5 according to various embodiments of the disclosure.
FIG. 7 is a partial enlarged cross-sectional view of an area 7 of the display panel in FIG. 6 according to various embodiments of the disclosure.
FIG. 8A to FIG. 8C are views showing a principle in which light totally reflected through an optical waveguide layer according to various embodiments of the disclosure is emitted through a light extraction part.
FIG. 9A is a partial configuration view of a display panel when the area 7 in FIG. 7 is seen from above according to various embodiments of the disclosure.
FIG. 9B is a partial configuration view of a display panel according to various embodiments of the disclosure.
FIG. 10 is a partial cross-sectional view of a display panel according to various embodiments of the disclosure.

### [Mode for the Invention]

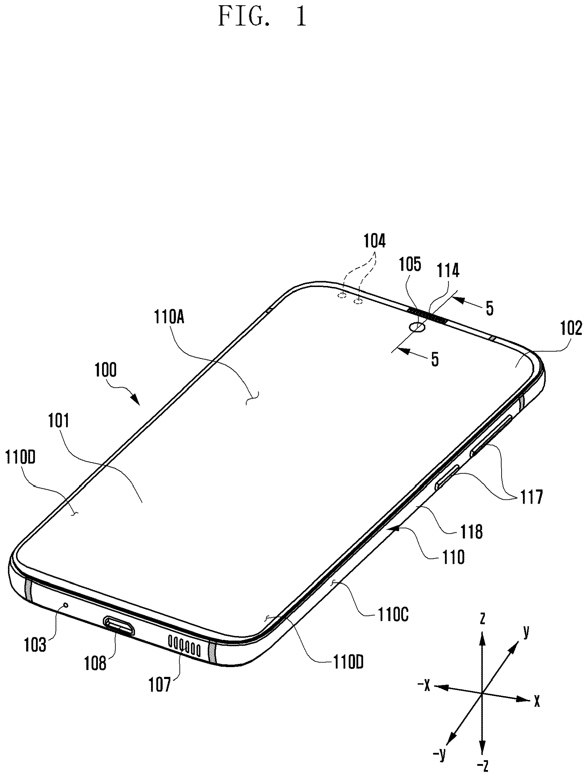

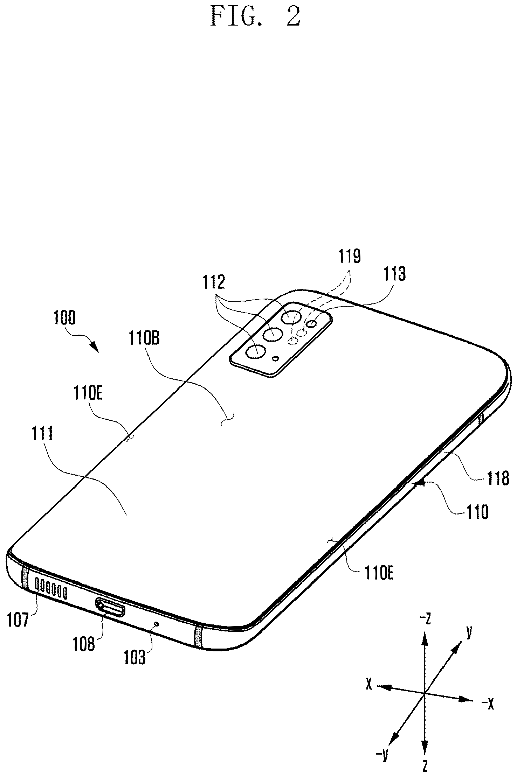

FIG. 1 illustrates a perspective view showing a front surface of a mobile electronic device according to an embodiment of the disclosure, and FIG. 2 illustrates a perspective view showing a rear surface of the mobile electronic device shown in FIG. 1 according to an embodiment of the disclosure.

Referring to FIGS. 1 and 2, a mobile electronic device 100 may include a housing 110 that includes a first surface (or front surface) 110A, a second surface (or rear surface) 110B, and a lateral surface 110C that surrounds a space between the first surface 110A and the second surface 11 0B. The housing 110 may refer to a structure that forms a part of the first surface 110A, the second surface 110B, and the lateral surface 110C. The first surface 110A may be formed of a front plate 102 (e.g., a glass plate or polymer plate coated with a variety of coating layers) at least a part of which is substantially transparent. The second surface 110B may be formed of a rear plate 111 which is substantially opaque. The rear plate 111 may be formed of, for example, coated or colored glass, ceramic, polymer, metal (e.g., aluminum, stainless steel (STS), or magnesium), or any combination thereof. The lateral surface 110C may be formed of a lateral bezel structure (or "lateral member") 118 which is combined with the front plate 102 and the rear plate 111 and includes a metal and/or polymer. The rear plate 111 and the lateral bezel structure 118 may be integrally formed and may be of the same material (e.g., a metallic material such as aluminum).

The front plate 102 may include two first regions 110D disposed at long edges thereof, respectively, and bent and extended seamlessly from the first surface 110A toward the rear plate 111. Similarly, the rear plate 111 may include two second regions 110E disposed at long edges thereof, respectively, and bent and extended seamlessly from the second surface 110B toward the front plate 102. The front plate 102 (or the rear plate 111) may include only one of the first regions 110D (or of the second regions 110E). The first regions 110D or the second regions 110E may be omitted in part. When viewed from a lateral side of the mobile electronic device 100, the lateral bezel structure 118 may have a first thickness (or width) on a lateral side where the first region 110D or the second region 110E is not included, and may have a second thickness, being less than the first thickness, on another lateral side where the first region 110D or the second region 110E is included.

The mobile electronic device 100 may include at least one of a display 101, audio modules 103, 107 and 114, sensor modules 104 and 119, camera modules 105, 112 and 113, a key input device 117, a light emitting device, and connector hole 108. The mobile electronic device 100 may omit at least one (e.g., the key input device 117 or the light emitting device) of the above components, or may further include other components.

The display 101 may be exposed through a substantial portion of the front plate 102, for example. At least a part of the display 101 may be exposed through the front plate 102 that forms the first surface 110A and the first region 110D of the lateral surface 110C. The display 101 may be combined with, or adjacent to, a touch sensing circuit, a pressure sensor capable of measuring the touch strength (pressure), and/or a digitizer for detecting a stylus pen. At least a part of the sensor modules 104 and 119 and/or at least a part of the key input device 117 may be disposed in the first region 110D and/or the second region 110E.

The audio modules 103, 107 and 114 may correspond to a microphone hole 103 and speaker holes 107 and 114, respectively. The microphone hole 103 may contain a microphone disposed therein for acquiring external sounds and, in a case, contain a plurality of microphones to sense a sound direction. The speaker holes 107 and 114 may be classified into an external speaker hole 107 and a call receiver hole 114. The microphone hole 103 and the speaker holes 107 and 114 may be implemented as a single hole, or a speaker (e.g., a piezo speaker) may be provided without the speaker holes 107 and 114.

The sensor modules 104 and 119 may generate electrical signals or data corresponding to an internal operating state of the mobile electronic device 100 or to an external environmental condition. The sensor modules 104 and 119 may include a first sensor module 104 (e.g., a proximity sensor) and/or a second sensor module (e.g., a fingerprint sensor) disposed on the first surface 110A of the housing 110, and/or a third sensor module 119 (e.g., a heart rate monitor (HRM) sensor) and/or a fourth sensor module (e.g., a fingerprint sensor) disposed on the second surface 110B of the housing 110. The fingerprint sensor may be disposed on the second surface 110B as well as the first surface 110A (e.g., the display 101) of the housing 110. The electronic device 100 may further include at least one of a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 105, 112 and 113 may include a first camera device 105 disposed on the first surface 110A of the electronic device 100, and a second camera device 112 and/or a flash 113 disposed on the second surface 110B. The camera module 105 or the camera module 112 may include one or more lenses, an image sensor, and/or an image signal processor. The flash 113 may include, for example, a light emitting diode or a xenon lamp. Two or more lenses (infrared cameras, wide angle and telephoto lenses) and image sensors may be disposed on one side of the electronic device 100.

The key input device 117 may be disposed on the lateral surface 110C of the housing 110. The mobile electronic device 100 may not include some or all of the key input device 117 described above, and the key input device 117 which is not included may be implemented in another form such as a soft key on the display 101. The key input device 117 may include the sensor module disposed on the second surface 110B of the housing 110.

The light emitting device may be disposed on the first surface 110A of the housing 110. For example, the light emitting device may provide status information of the electronic device 100 in an optical form. The light emitting device may provide a light source associated with the operation of the camera module 105. The light emitting device may include, for example, a light emitting diode (LED), an IR LED, or a xenon lamp.

The connector hole 108 may include a first connector hole 108 adapted for a connector (e.g., a universal serial bus (USB) connector) for transmitting and receiving power and/or data to and from an external electronic device. The connector hole 108 may include a second connector hole (not shown) adapted for a connector (e.g., an earphone jack) for transmitting and receiving an audio signal to and from an external electronic device.

Some sensor modules 105 of camera modules 105 and 112, some sensor modules 104 of sensor modules 104 and 119, or an indicator may be arranged to be exposed through a display 101. For example, the camera module 105, the sensor module 104, or the indicator may be arranged in the internal space of an electronic device 100 so as to be brought into contact with an external environment through an opening of the display 101, which is perforated up to a front plate 102. According to an embodiment, an area corresponding to some camera module 105 of the display 101 is a part of an area in which content is displayed, and may be formed as a transmission area having designated transmittance. For example, the transmission area may be formed to have transmittance having a range of about 5% to about 20%. The transmission area may include an area overlapped with a valid area (e.g., a field of view (FOV)) of the camera module 105 through which light imaged by an image sensor and for generating an image passes. For example, a transmission area of the display 101 may include an area in which the density of pixels and/or a wiring density are lower than that of surroundings. The camera module 305 may include, for example, under display camera (UDC). In an embodiment, some sensor modules 104 may be arranged to perform their functions without being visually exposed through the front plate 102 in the internal space of the electronic device. For example, in this case, an area of the display 101 facing the sensor module may not require a perforated opening.

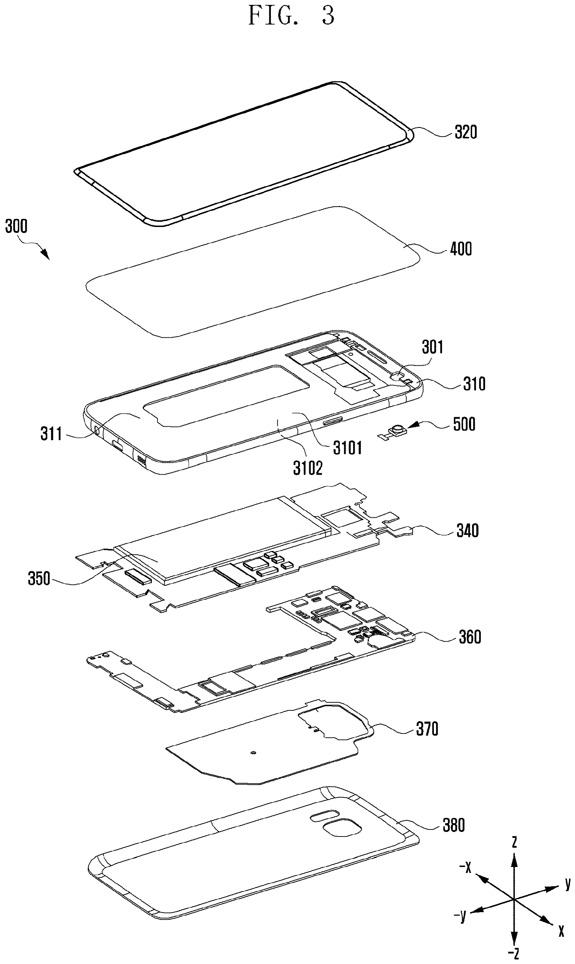

According to various embodiments, the electronic apparatus 100 may have a bar-type appearance or a plate-type appearance, but the disclosure is not limited thereto. For example, the illustrated electronic apparatus 100 may be a part of a foldable electronic apparatus, a slidable electronic apparatus, a stretchable electronic apparatus, and/or a rollable electronic apparatus. A "foldable electronic apparatus", a "slidable electronic apparatus", a "stretchable electronic apparatus", and/or a "rollable electronic apparatus" may mean an electronic apparatus in which a display (e.g., the display 400 in FIG. 3) may be bent and deformed so that at least a portion of the display is folded or wound or rolled, an area of the display is at least partially expanded, and/or the display is accommodated inside a housing (e.g., the housing 110 in FIG. 1 and FIG. 2). A foldable electronic apparatus, a slidable electronic apparatus, a stretchable electronic apparatus, and/or a rollable electronic apparatus may be configured such that a display is unfolded or a larger area of a display is exposed to the outside so as to expand and then enable the use of a screen display area thereof, according to user needs.

FIG. 3 illustrates an exploded perspective view showing a mobile electronic device shown in FIG. 1 according to an embodiment of the disclosure.

The electronic device 300 in FIG. 3 may be at least partially similar to the electronic device 100 in FIG. 1 and FIG. 2 or may further include other embodiments.

Referring to FIG. 3, a mobile electronic device 300 may include a lateral bezel structure 310, a first support member 311 (e.g., a bracket), a front plate 320, a display 330, an electromagnetic induction panel (not shown), a printed circuit board (PCB) 340, a battery 350, a second support member 360 (e.g., a rear case), an antenna 370, and a rear plate 380. The mobile electronic device 300 may omit at least one (e.g., the first support member 311 or the second support member 360) of the above components or may further include another component. Some components of the electronic device 300 may be the same as or similar to those of the mobile electronic device 100 shown in FIG. 1 or FIG. 2, thus, descriptions thereof are omitted below.

The first support member 311 is disposed inside the mobile electronic device 300 and may be connected to, or integrated with, the lateral bezel structure 310. The first support member 311 may be formed of, for example, a metallic material and/or a non-metal (e.g., polymer) material. The first support member 311 may be combined with the display 330 at one side thereof and also combined with the printed circuit board (PCB) 340 at the other side thereof. On the PCB 340, a processor, a memory, and/or an interface may be mounted. The processor may include, for example, one or more of a central processing unit (CPU), an application processor (AP), a graphics processing unit (GPU), an image signal processor (ISP), a sensor hub processor, or a communications processor (CP).

The memory may include, for example, one or more of a volatile memory and a nonvolatile memory.

The interface may include, for example, a high definition multimedia interface (HDMI), a USB interface, a secure digital (SD) card interface, and/or an audio interface. The interface may electrically or physically connect the mobile electronic device 300 with an external electronic device and may include a USB connector, an SD card/multimedia card (MMC) connector, or an audio connector.

The battery 350 is a device for supplying power to at least one component of the mobile electronic device 300, and may include, for example, a non-rechargeable primary battery, a rechargeable secondary battery, or a fuel cell. At least a part of the battery 350 may be disposed on substantially the same plane as the PCB 340. The battery 350 may be integrally disposed within the mobile electronic device 300, and may be detachably disposed from the mobile electronic device 300.

The antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may perform short-range communication with an external device, or transmit and receive power required for charging wirelessly. An antenna structure may be formed by a part or combination of the lateral bezel structure 310 and/or the first support member 311.

According to various embodiments, the first support member 311 of the lateral member 310 may include a first surface 3101 facing the front plate 320 and a second surface 3102 oriented in a direction (e.g., the direction of a rear plate) opposite to the first surface 3101. According to an embodiment, a camera module 500 (e.g., the first camera module 105 in FIG. 1) may be disposed between the first support member 311 and the rear plate 380. According to an embodiment, the camera module 500 may protrude or be disposed to be visible, in the direction of the front plate 320 through a through-hole 301 connected from the first surface 3101 up to the second surface 3102 of the first support member 311. According to an embodiment, a portion of the camera module 500, which protrudes through the through-hole 301, may be disposed to detect an external environment at a corresponding position of the display 400. As another embodiment, in case that the camera module 500 is disposed between the display 400 and the first support member 311, the through-hole 301 may be unnecessary.

Hereinafter, in the electronic apparatus 300, the structure of the display 400 will be described in detail.

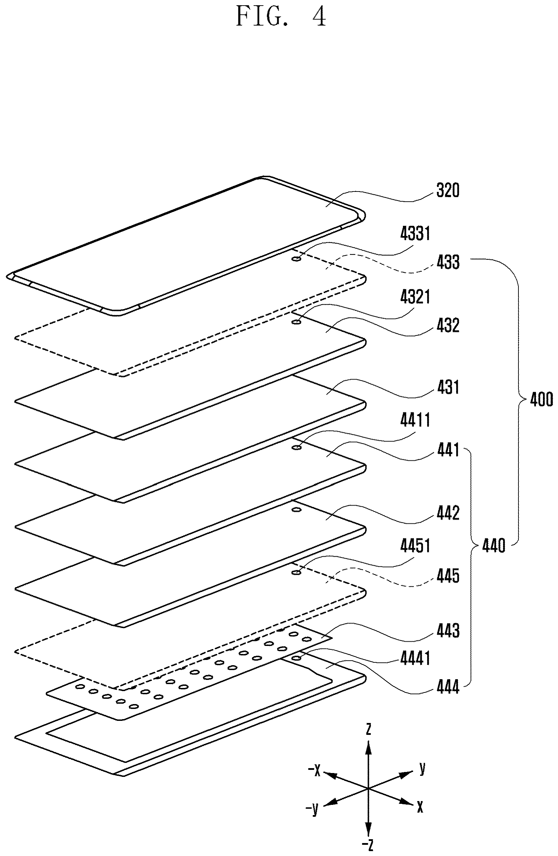

FIG. 4 is an exploded perspective view of a display 400 according to various embodiments of the disclosure.

The display 400 in FIG. 4 may be at least partially similar to the display 101 in FIG. 1, or may further include another embodiment of a display.

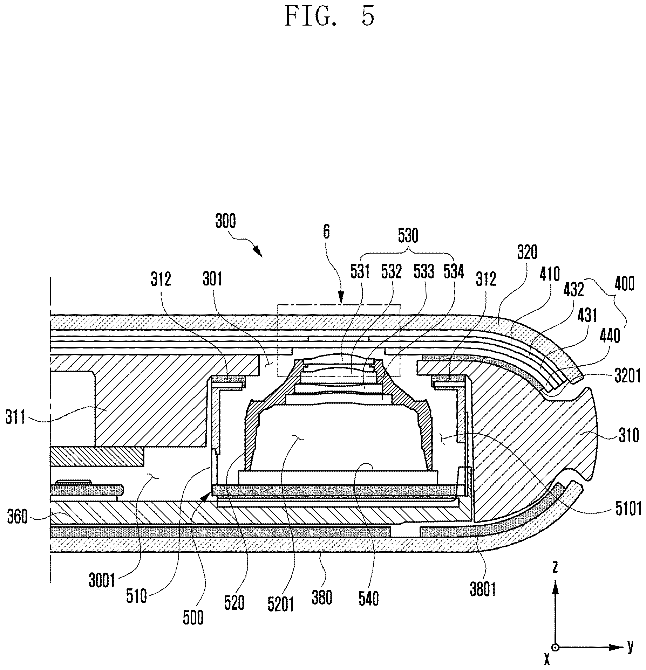

Referring to FIG. 4, the display 400 may include a polarizer (POL) 432 (e.g., a polarization film or a polarization layer) and a display panel 431 which are sequentially disposed on the rear surface of the front cover 320 (e.g., a front plate, a glass plate, a first cover member, or a cover member) through an adhesive member (e.g., an adhesive member 410 in FIG. 5), and at least one subsidiary material layer 440 attached to the rear surface of the display panel 431. According to an embodiment, the adhesive member 410 may include an optical clear adhesive (OCA), a pressure sensitive adhesive (PSA), a heat-reactive adhesive, a general adhesive, or a double-sided tape. According to an embodiment, the display panel 431 and the POL 432 may also be integrally formed.

According to various embodiments, the display 400 may include a control circuit (not shown). According to an embodiment, the control circuit may include a flexible printed circuit board (FPCB) for electrically connecting a main printed circuit board (e.g., the printed circuit board 340 in FIG. 3) and the display panel 431 of an electronic apparatus (e.g., the electronic apparatus 300 in FIG. 3), and a display driver IC (DDI) mounted on the FPCB. According to an embodiment, the display 400 may also additionally include a touch panel 433. According to an embodiment, in a case where the display 400 operates as an in-cell type or an on-cell type touch display according to the arrangement position of the touch panel 433, the control circuit may also include a touch display driver IC (TDDI). As another embodiment, the display 400 may also include a fingerprint sensor (not shown) disposed around the control circuit. According to an embodiment, the fingerprint sensor may include an ultrasonic type or an optical type fingerprint sensor capable of recognizing a fingerprint of a finger, which is in contact with the sensor from or is adjacent to the outer surface of the front cover 320 through a hole at least partially formed through a part of elements of the display 400.

According to various embodiments, the at least one subsidiary material layer 440 may include at least one polymer member 441 or 442 disposed on the rear surface of the display panel 431, at least one functional member 443 disposed on the rear surface of the at least one polymer member 441 or 442, and a conductive member 444 disposed on the rear surface of the at least one functional member 443. According to an embodiment, the at least one polymer member 441 or 442 may include a light-blocking layer 441 (e.g., a black layer with a bumpy pattern) for removing air bubbles which may occur between the display panel 431 and the lower attachment members and for blocking light generated in the display panel 431 or incident light from the outside, and/or a buffer layer 442 disposed to mitigate impact. According to an embodiment, the at least one functional member 443 may include a heat dissipation sheet (e.g., a graphite sheet) for heat dissipation, an added display, a force touch FPCB, a fingerprint sensor FPCB, an antenna radiator for communication, a conductive or a non-conductive tape, or an open cell sponge. According to an embodiment, the conductive member 444 may be a metal plate, and may be used in order to help rigidity reinforcement of an electronic apparatus (e.g., the electronic apparatus 300 in FIG. 3), block ambient noise, and disperse heat emitted from heat dissipating components therearound. According to an embodiment, the conductive member 444 may include Cu, Al, Mg, SUS, or CLAD (e.g., a lamination member in which SUS and Al are alternately arranged). As another embodiment, the display 400 may also further include a detection member 445 for detecting an input by a writing member (e.g., an electronic pen) of an electromagnetic induction type. According to an embodiment, the detection member 445 may include a digitizer. According to an embodiment, the detection member 445 may be disposed between the at least one polymer member 442 and the functional member 443. As another embodiment, the detection member 445 may also be disposed between the display panel 431 and the at least one polymer member 441. As another embodiment, the detection member 445 may also be disposed on the rear surface of a conductive member 444.

According to various embodiments, the subsidiary material layer 440 may include openings 4411, 4421, 4451, and 4441 formed at a position corresponding to a camera module (e.g., the camera module 500 in FIG. 5). According to an embodiment, the camera module 500 may be disposed to be close to the rear surface of the display panel 431 through the openings 4411, 4421, 4451, and 4441. According to an embodiment, in order to prevent performance degradation of the camera module 500 due to a refractive index thereof, the POL 432 or the touch panel 433 disposed on or above the display panel 431 may also include openings 4321 and 4331 formed by perforating a portion at a corresponding portion. As another embodiment, a portion at a position of the POL 432 and/or the touch panel 433, which corresponds to the camera module 500, may be processed transparently or may not have polarization properties. As another embodiment, in order to minimize the refractive index difference therebetween, layers (e.g., the display panel 431) not having an opening and/or the touch panel 433 may also include a coating layer capable of index matching. According to an embodiment, the display 400 may include an organic light emitting diode (OLED) display or a liquid crystal display (LCD).

FIG. 5 is a partial cross-sectional view of an electronic apparatus 300 seen from line 5-5 in FIG. 1 according to various embodiments of the disclosure.

In explaining FIG. 5, an unbreakable (UB) type OLED display (e.g., a curved display) will be described as an example, but it is not limited thereto. For example, it may also be applied to a flat type display of an on-cell touch active-matrix organic light-emitting diode (AMOLED) (OCTA) type.

Referring to FIG. 5, the electronic apparatus 300 may include the front cover 320 (e.g., a cover member, a front plate, a front window, or a first plate) oriented in a first direction (the z-axis direction), the rear cover 380 (e.g., a rear cover member, a rear plate, a rear window, or a second plate) oriented in a direction opposite to the front cover 320, and a lateral member 310 for surrounding a space 3001 between the front cover 320 and the rear cover 380. According to an embodiment, the electronic apparatus 300 may include a first waterproof member 3201 disposed between the subsidiary material layer 440 of the display 400 and the lateral member 310. According to an embodiment, the electronic apparatus 300 may include a second waterproof member 3801 disposed between the lateral member 310 and the rear cover 380. The first waterproof member 3201 and the second waterproof member 3801 may prevent foreign materials or moisture from being introduced into the inner space 3001 of the electronic apparatus 300. As another embodiment, the waterproof member may also be disposed in at least a part of a mounting support structure between the camera module 500 and the lateral member 310. As another embodiment, the first waterproof member 3201 and/or the second waterproof member 3801 may also be replaced with an adhesive member.

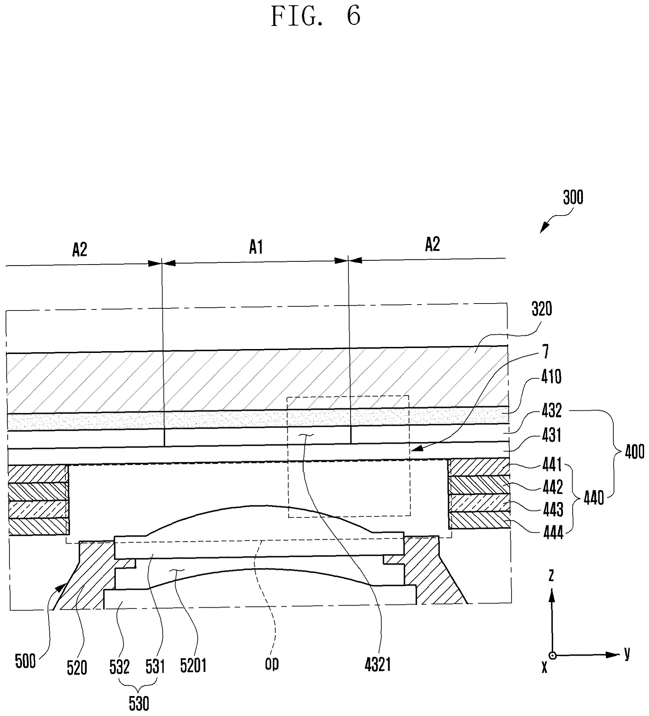

According to various embodiments, the lateral member 310 may further include a first support member 311 which at least partially extends to the inner space 3001 of the electronic apparatus 300. According to an embodiment, the first support member 311 may also be formed by structural coupling with the lateral member 310. According to an embodiment, the first support member 311 may support the camera module 500 so that the camera module 500 is aligned and disposed near the rear surface of the display panel 431 through an opening (e.g., the opening OP in FIG. 6) of the subsidiary material layer 440 of the display 400.

According to various embodiments, the camera module 500 may include a camera housing 510, a lens housing 520 which is disposed in an inner space 5101 of the camera housing 510 and protrudes to be at least partially oriented in the direction (e.g., z-axis direction) of the display, multiple lenses 530: 531, 532, 533, and 534 arranged at predetermined intervals in the inner space 5201 of the lens housing 520, and at least one image sensor 540 disposed to obtain at least a part of light passing through the multiple lenses 530 in the inner space 5101 of the camera housing 510. According to an embodiment, in case that the camera module 500 has an auto focus (AF) function, the lens housing 520 may move in the camera housing 510 through a drive unit so that the distance to the display panel 431 is varied. According to an embodiment, in order for the camera module 500 to perform an AF function, a separate drive unit may be disposed to change the position of at least one lens among the multiple lenses 530. As another embodiment, in the camera module 500, the camera housing 510 may be omitted, and the lens housing 520 may also be directly disposed in the first support member 311 through a predetermined alignment process. According to an embodiment, in case that the lens housing is directly disposed in in the first support member 311, in order to reduce a camera arrangement space, the camera housing 510 may be omitted, and the lens housing 520 may be disposed to be attached to one side of the first support member 311. According to an embodiment, the camera module 500 may be attached to the rear surface of the first support member 311 through an adhesive member 312 (e.g., a bonding member or a tape member) after being aligned through the through-hole 301 of the first support member 311.

According to various embodiments, the display 400 may include a touch panel (e.g., the touch panel 433 in FIG. 4), the POL 432, the display panel 431, the light-blocking layer 441, a buffer layer (e.g., the buffer layer 442 in FIG. 4), a digitizer (e.g., the detection member 445 in FIG. 4), a functional member (e.g., the functional member 443 in FIG. 4), and/or a conductive member (e.g., the conductive member 444 in FIG. 4). According to an embodiment, the camera module 500 may also be supported by the second support member 360 (e.g., a rear case) additionally disposed in an inner space of an electronic apparatus.

FIG. 6 is an enlarged view of an area 6 in FIG. 5 according to various embodiments of the disclosure.

Referring to FIG. 6, the electronic apparatus 300 may include the adhesive member 410, the POL 432, the display panel 431, and the subsidiary material layer 440 which are arranged between the lateral member 310 and the rear surface of the front cover 320. According to an embodiment, when the front cover 320 is seen from above, the POL 432 may include the opening 4321 formed to improve the optical transmittance of the camera module 500. As another embodiment, the adhesive member 410 disposed on the POL 432 may also have a portion which corresponds to the opening 4321 and is at least partially omitted. In some embodiments, the opening 4321 formed through the POL 432 may also be filled with an index material to adjust a refractive index according to the increase in interface reflection. According to an embodiment, the POL 432 may be omitted, and the corresponding portion may also be replaced with a color filter layer including a color filter and a black mask. Even in this case, the color filter layer may include an opening in order to improve the optical transmittance of a camera module.

According to an embodiment, an area corresponding to the multiple lenses 530 of the POL 432 may not have an opening 4321 formed therethrough, and may also be formed to have a high transmittance. For example, at least a partial area (e.g., the area corresponding to multiple lenses 530) of the POL 432 may be formed of a material having a transmittance different from those of the remaining areas of the POL 432, or may include other members capable of improving the transmittance. According to an embodiment, a member (not shown) for improving a transmittance may also be disposed on at least a part (e.g., the upper side surface or the lower side surface) of an area of the POL 432, which corresponds to the multiple lenses 530. According to an embodiment, when the front cover 320 is seen from above, the subsidiary material layer 440 may include an opening OP formed in an area which at least partially overlaps the multiple lenses 530. According to an embodiment, the opening OP formed through the subsidiary material layer 440 may be formed to have one opening OP in a form in which an opening (e.g., the opening 4411 in FIG. 4) formed through the light-blocking layer 441, an opening (e.g., the opening 4421 in FIG. 4) formed through the buffer layer 442, an opening (e.g., the opening 4431 in FIG. 4) formed through functional member 443, and an opening (e.g., the opening 4441 in FIG. 4) formed through the conductive member 444 overlap each other. According to an embodiment, the openings may have different sizes, respectively, to correspond to the shape of the camera module 500.

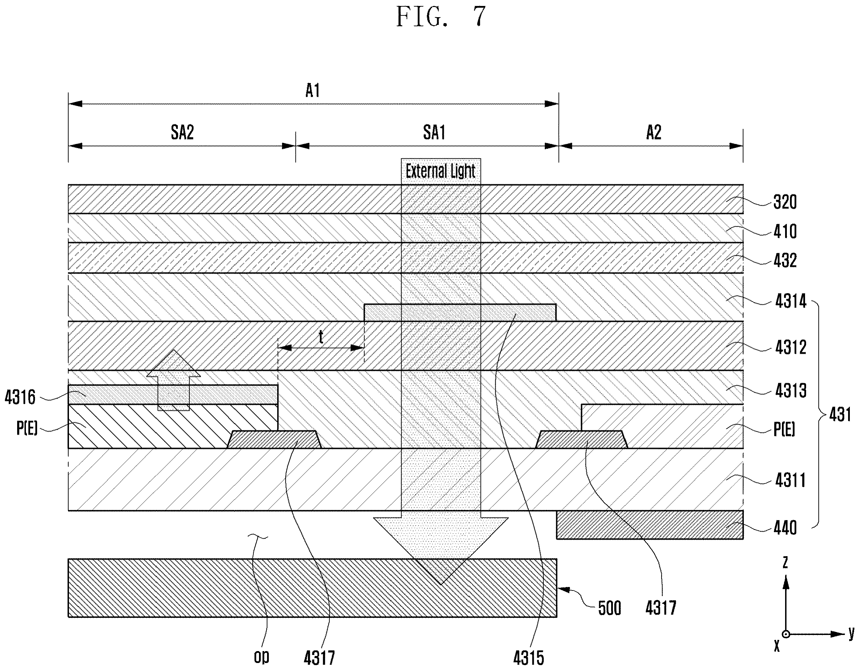

According to various embodiments, when the display 400 is seen from above, the display panel 431 may include a first area A1 overlapping the effective aperture of the camera module 500 and a second area A2 for surrounding the first area A1. According to an embodiment, the first area A1 may be configured such that a pixel density and/or a wire density thereof is adjusted, and thus may be formed to have a light transmittance required by the camera module 500. According to an embodiment, the second area A2 may include a general active area of the display panel 431. According to an embodiment, the second area A2 may be an area in which a light transmittance for the camera module 500 is not considered. According to an embodiment, the display panel 431 may include first multiple pixels (e.g., P in FIG. 7) arranged to have a first arrangement density in the first area A1, and second multiple pixels (e.g., P in FIG. 7) having a second arrangement density in the second area A2, which is higher than the first arrangement density. In some embodiments, the first area A1 may be formed to have a wire density lower than the wire density of the second area A2 so as to help the improvement in transmittance.

According to various embodiments, the first area A1 of the display panel 431 may have a pixel density lower than the second area A2 therearound, and thus a non-emitting light-transmitting area (e.g., the first sub-area SA1 in FIG. 7) between a pixel and a pixel may be recognized as black and thus be visible from the outside. The display panel 431 according to exemplary embodiments of the disclosure may be configured such that at least a part of light generated through the pixels is totally reflected to an optical waveguide layer (e.g., the optical waveguide layer 4312 in FIG. 7) and may include a light extraction part (e.g., the light extraction part 4315 in FIG. 7) for inducing light to be emitted to the outside through the light-transmitting area, and thus such problems may be solved.

Hereinafter, the structure of the display panel 431 will be described in detail.

FIG. 7 is a partial enlarged cross-sectional view of an area 7 of the display panel in FIG. 6 according to various embodiments of the disclosure.

In describing FIG. 7, each of the multiple pixels P may include a configuration including a light-emitting part E in which light corresponding to a corresponding color is expressed through an arrangement structure of electrodes and an organic materials.

In order to explain the arrangement structure of a light extraction part 4315 and a light injection part 4316, the arrangement structure of the pixels P between the first area A1 and the second area A2 is illustrated in FIG. 7. Although not illustrated therein, it may be obvious that the first area A1 is disposed between the multiple pixels P and includes first multiple sub-areas SA1 described below. Referring to FIG. 7, the display panel 431 may include a substrate 4311, and a first buffer layer 4313, an optical waveguide layer 4312, and a second buffer layer 4314 which are sequentially laminated on the substrate 4311. According to an embodiment, when the display panel 431 is seen from above, the first area A1 of display panel 431 may include a first sub-area SA1 overlapping the space between the multiple pixels P, and a second sub-area SA2 overlapping the multiple pixels P and the light-emitting part E. According to an embodiment, the multiple pixels P may be arranged through the first buffer layer 4313, and an interval between the pixels may be determined through a pixel define layer 4317. According to an embodiment, for example, each of the multiple pixels P may be defined as a first sub-pixel (e.g., a red pixel), a second sub-pixel (e.g., a green pixel), or a third sub-pixel (e.g., a blue pixel). Accordingly, the first sub-area SA1 may mean a light-transmitting area for the camera module 500, between the multiple pixels P. According to an embodiment, the light-emitting part may include a counter electrode and a pixel electrode (e.g., a reflective electrode) arranged while having an organic material layer interposed therebetween. According to an embodiment, the substrate 4311 may include an electrical connection member for electrically connecting pixel electrodes to each other. According to an embodiment, the electrical connection member may include a thin film transistor (TFT) or a low temperature passivation transistor (LTPS).

According to various embodiments, the first buffer layer 4313 may be a protective layer, and may be formed to protect electrodes and an organic material layer and to provide a flat screen for the optical waveguide layer 4312 disposed thereon. According to an embodiment, the second buffer layer 4314 may also be a protective layer, and may be disposed on the optical waveguide layer 4312 and may provide a flat screen for the POL 432 and/or a touch sensor layer arranged thereon. In some embodiments, the first buffer layer 4313 and the second buffer layer 4314 may be configured to have a refractive index different from that of the optical waveguide layer 4312 disposed therebetween and thus may provide help in a total reflection condition of the optical waveguide layer 4312. According to an embodiment, the first buffer layer 4313 and/or the second buffer layer 4314 may include a layer in which at least one inorganic film of a silicon nitride layer, a silicon oxy nitride layer, a silicon oxide layer, a titanium oxide layer, or an aluminum oxide layer is alternately laminated. According to an embodiment, in case that the material of the optical waveguide layer 4312 is made of glass, the second buffer layer 4314 may be air. According to an embodiment, the first buffer layer 4313 and/or the second buffer layer 4314 may be formed such that at least a part of light introduced from the light-emitting part to the optical waveguide layer 4312 has a refractive index satisfying a total reflection condition at a corresponding incidence angle. According to an embodiment, the optical waveguide layer 4312 may include an encapsulation layer disposed on the first buffer layer 4313.

According to various embodiments, the display panel 431 may include the light extraction part 4315 disposed in an area which at least partially overlaps the first sub-area SA1. According to an embodiment, in order to emit at least a part of light delivered through the optical waveguide layer 4312 to the outside, the light extraction part 4315 may be formed to have a refractive index capable of breaking the total reflection condition of the optical waveguide layer 4312. According to an embodiment, the light extraction part 4315 may be disposed on the optical waveguide layer 4312 to be protected through the second buffer layer 4314. According to an embodiment, the light extraction part 4315 may include one single layer disposed on the optical waveguide layer 4312 in at least a part of the first sub-area SA1. In some embodiments, the light extraction part 4315 may also be replaced with multiple light extraction parts arranged on the optical waveguide layer 4312 at designated intervals in at least a part of the first sub-area SA1. For example, in case that multiple light extraction parts have the same size, the multiple light extraction parts may be arranged such that the arrangement density thereof gradually increases from the outer side of the first sub-area SA1 toward the center. For example, in case that multiple light extraction parts have different sizes, the multiple light extraction parts may be arranged to have a size which gradually increases from the outer side of the first sub-area SA1 toward the center.

According to various embodiments, the display panel 431 may include the light injection part 4316 (e.g., a light collection part) disposed in an area which at least partially overlaps the second sub-area SA2 and corresponds to the pixels P including the light-emitting part E. According to an embodiment, the refractive indices of the light injection part 4316 or light extraction part 4315 may be determined according to a ratio of the amount of light which is emitted from the light-emitting part and reaches the light extraction part 4315 through the optical waveguide layer 4312. According to an embodiment, the light injection part 4316 may be disposed between the optical waveguide layer 4312 and the pixels P in the first buffer layer 4313. According to an embodiment, when the display panel 431 is seen from above, in the inside (an optical waveguide layer) thereof, for the movement of light due to a total reflection, the optical waveguide layer 4312 may include a total internal reflection (TIR) area t which does not overlap the light extraction part 4315 and the light injection part 4316. In some embodiments, the total internal reflection area t may also be omitted. In some embodiments, the optical waveguide layer 4312 may at least partially have a concave/convex shape. In this case, a concave/convex shape in a portion corresponding to the first area A1 and a concave/convex shape in a portion corresponding to the second area A2 may be different from each other. According to an embodiment, a refractive index of the light injection part 4316 may be smaller than a refractive index of the light extraction part 4315. According to an embodiment, the optical waveguide layer 4312, the light extraction part 4315, and/or the light injection part 4316 may be formed of an organic film or an organic film including an inorganic particle. According to an embodiment, the organic film may be an acrylic resin, an epoxy resin, a phenolic resin, a polyamide resin, or a polyimide resin, but is not limited thereto. According to an embodiment, the inorganic particle may be a metal particle, but is not limited thereto.

According to an exemplary embodiment of the disclosure, at least a part of light emitted through the light-emitting part and the pixels P may be delivered to the optical waveguide layer 4312 through the light injection part 4316 having a designated refractive index, in the second sub-area SA2. According to an embodiment, the light delivered to the optical waveguide layer 4312 may reach the light extraction part 4315 disposed in the first sub-area SA1 through a total reflection, in at least a part (e.g., the total internal reflection area t) of the optical waveguide layer 4312. According to an embodiment, at least a part of the light delivered through the optical waveguide layer 4312 may be emitted to the outside of the display panel 431, through the light extraction part 4315 formed to have a refractive index which breaks the total reflection condition of the optical waveguide layer 4312. Accordingly, in the first area A1 corresponding to the camera module 500, a light guide structure according to an exemplary embodiment of the disclosure, in which at least a part of light generated from the light-emitting part is diffused to the first sub-area SA1 in which the light-emitting part is not disposed and then is emitted to the outside, may help to reduce external visibility of the display 400 corresponding to the arrangement area of the camera module.

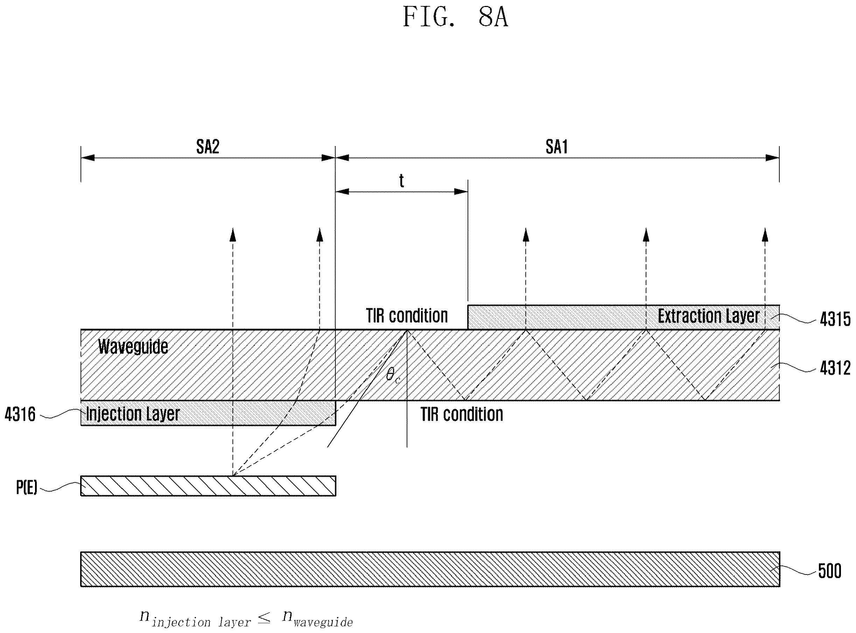

FIG. 8A to FIG. 8C are views showing a principle in which light totally reflected through an optical waveguide layer according to various embodiments of the disclosure is emitted through a light extraction part.

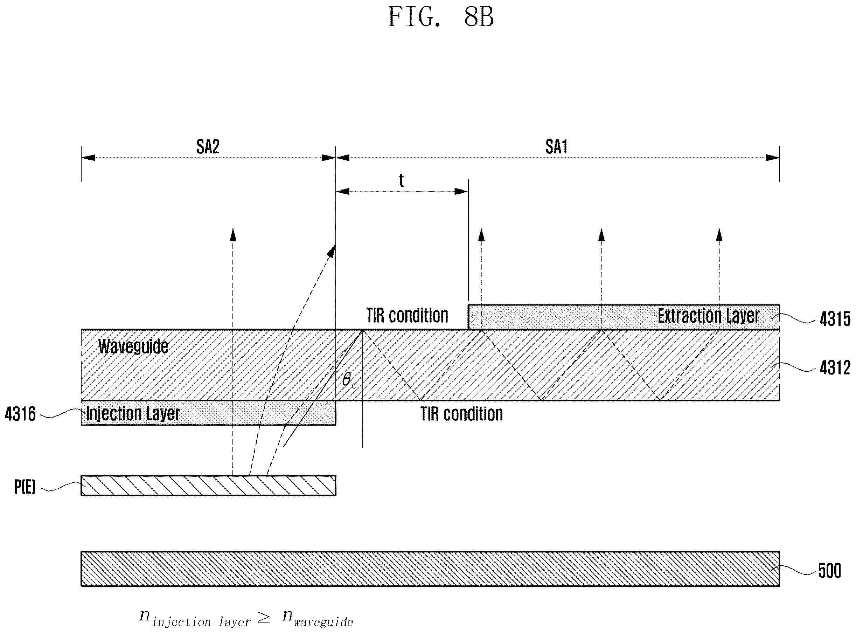

Referring to FIG. 8A and FIG. 8B, light emitted from the light-emitting part may enter the inside of the optical waveguide layer 4312 through the light injection part 4316 and be emitted to the light extraction part 4315 through a total reflection thereof. In this case, a refractive index of the light injection part 4316 may be determined according to the amount of light emitted through the light extraction part 4315. According to an embodiment, light incident at an angle greater than a critical angle θC may be totally reflected through the optical waveguide layer 4312, and be emitted through the light extraction part 4315. For example, as illustrated in FIG. 8A, in case that the refractive index n_{injection layer} of the light injection part 4316 is smaller than the refractive index n_{waveguide} of the optical waveguide layer 4312, an amount of light totally reflected through the optical waveguide layer 4312 and emitted through the light extraction part 4315 may be relatively small. In addition, as illustrated in FIG. 8B, in case that the refractive index n_{injection layer} of the light injection part 4316 is greater than the refractive index n_{waveguide} of the optical waveguide layer 4312, an amount of light totally reflected through the optical waveguide layer 4312 and emitted through the light extraction part 4315 may become relatively large.

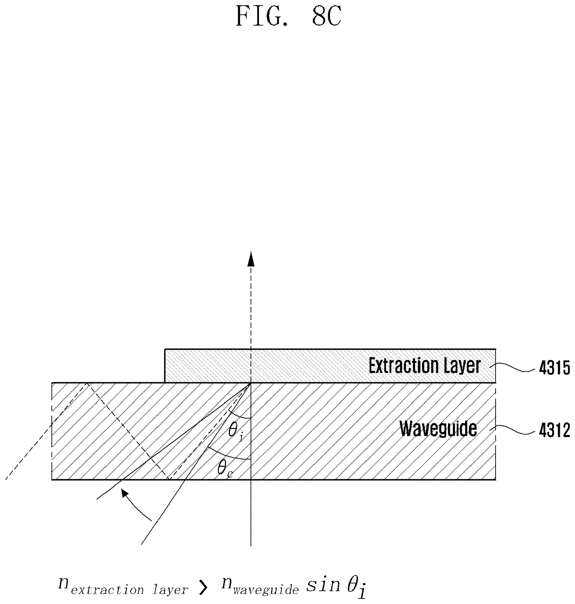

As illustrated in FIG. 8C, the light extraction part 4315, at the boundary surface with the optical waveguide layer 4312, may break the total reflection condition at the incident angle of light and thus may induce so that a part of light is transmitted thereto. According to an embodiment, the light, which is not transmitted through the light extraction part 4315, may be totally reflected inside the optical waveguide layer 4312 until the light meets the light extraction part 4315 again. Therefore, the light extraction part 4315 may be configured to have a refractive index n_{extraction layer} greater than the refractive index n_{waveguide} * sinθi of the optical waveguide layer 4312 so that a part of light is transmitted in the light extraction part 4315. According to an embodiment, in order to lower the reflectivity to which light directed to the camera module 500 from the outside is subjected, the refractive index of the light extraction part 4315 may be determined to a level which may minimize a difference in a refractive index with the outer boundary surface of the light extraction part 4315 while breaking the total reflection condition. For example, the light extraction part 4315 may be formed of a material having low light reflectivity for light entered for the sake of the camera module 500, and a refractive index capable of breaking the total reflection condition at the inner boundary surface of the optical waveguide layer 4312.

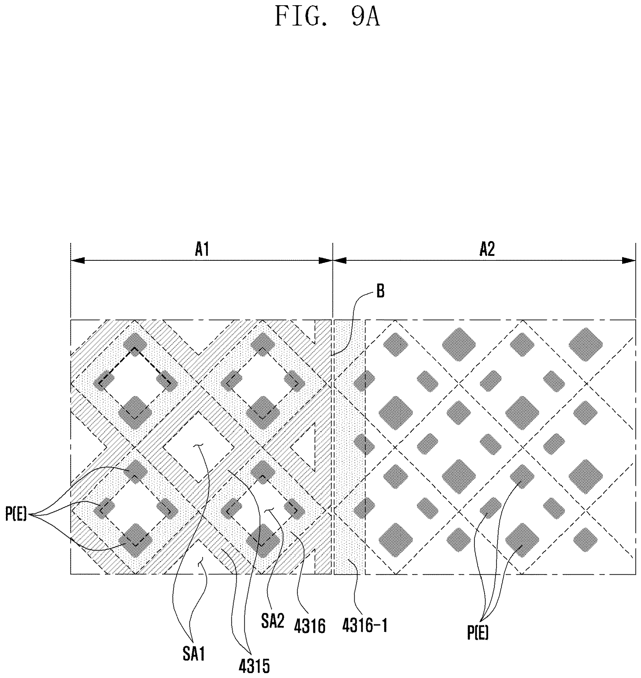

FIG. 9A is a partial configuration view of a display panel when the area 7 in FIG. 6 is seen from above according to various embodiments of the disclosure.

Referring to FIG. 9A, when the display 400 is seen from above, the display panel may include the first area A1 overlapping the effective aperture of the camera module 500 and a second area A2 for surrounding the first area A1. According to an embodiment, the display panel 431 may include first multiple pixels P arranged to have the first arrangement density in the first area A1, and second multiple pixels P having the second arrangement density in the second area A2, which is higher than the first arrangement density. According to an embodiment, when the display panel 431 is seen from above, the first area A1 of display panel 431 may include the first sub-area SA1 overlapping the space between the multiple pixels P, and the second sub-area SA2 overlapping the multiple pixels P and the light-emitting part.

According to various embodiments, the light extraction part 4315, in the first sub-area SA1 in which the pixels P are not arranged, may be disposed only in a part. For example, the light extraction part 4315 may be disposed to have a designated width along the edge of the first sub-area SA1. The reason is to prevent that the color of light emitted from the second sub-area SA2 is mixed with the color of light emitted from adjacent pixels. According to an embodiment, the light injection part 4316, in the second sub-area SA2, may be disposed only in a part. According to an embodiment, the light injection part 4316 may be disposed to have a designated width along the edge of the second sub-area SA2. In some embodiments, the light injection part 4316 may also be disposed in the entire second sub-area SA2. In some embodiments, in order to reduce the boundary visibility between the first area A1 and the second area A2, in a boundary portion B between the first area A1 and the second area A2, a light injection part 4316-1 may also be further disposed to have a designated width in the second area A2.

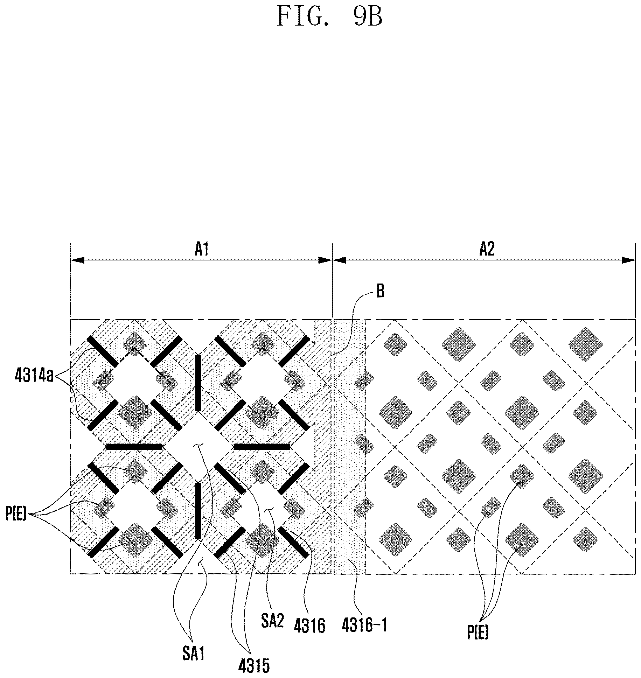

FIG. 9B is a partial configuration view of a display panel according to various embodiments of the disclosure.

In explaining the display panel in FIG. 9B, in relation to elements substantially the same as those in FIG. 9A, the same reference numerals will be used, and detailed descriptions thereof may be omitted.

Referring to FIG. 9B, an optical waveguide layer (e.g., the optical waveguide layer 4312 in FIG. 7) may include at least one segment part 4314a for optically separating each of multiple pixels. According to an embodiment, the at least one segment part 4314a may include an air gap formed in an optical waveguide layer. According to an embodiment, the at least one segment part 4314a may also further include a light-blocking material filled in the air gap. According to an embodiment, the mixing of the color of light emitted from the second sub-area SA2 through the at least one segment part 4314a with the color of light emitted from adjacent pixels P may be reduced.

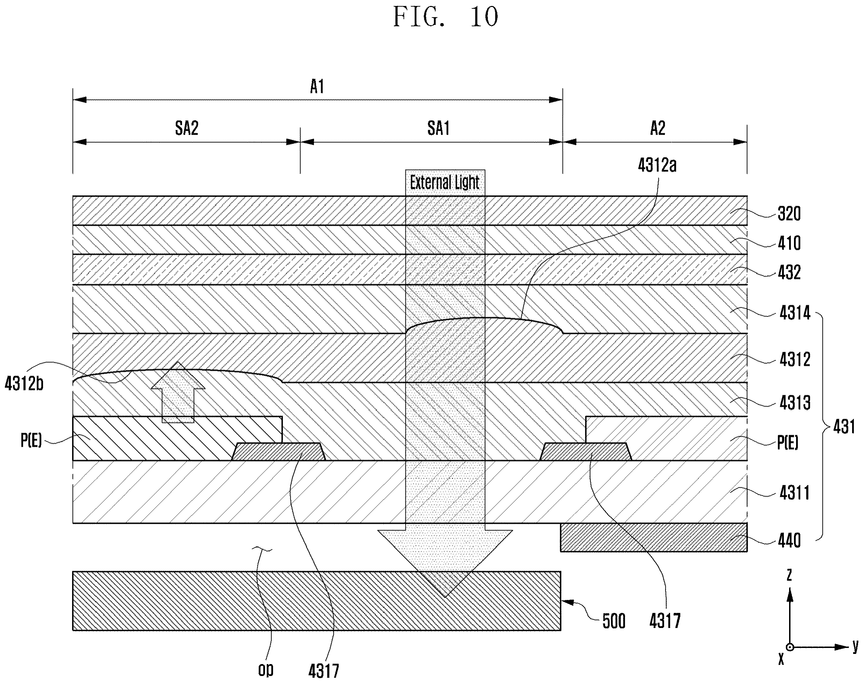

FIG. 10 is a partial cross-sectional view of a display panel according to various embodiments of the disclosure.

In explaining the display panel 431 in FIG. 10, in relation to elements substantially the same as those in the display panel 431 in FIG. 7, the same reference numerals will be used, and detailed descriptions thereof may be omitted.

Referring to FIG. 10, a light extraction part 4315 and a light injection part 4316 respectively arranged on the upper and the lower part of the optical waveguide layer 4312 may not be separate layers, and may also be configured through its own processing area of the optical waveguide layer 4312. For example, the light extraction part 4315, in the first sub-area SA1, may be replaced with a protruding area (a convex portion) 4312a formed in a curved shape higher than the outer surface from the upper surface of the optical waveguide layer 4312. According to an embodiment, the light injection part 4316, in the second sub-area SA2, may also be replaced with a concave area (a concave portion) 4312b formed in a curved shape lower than the outer surface from the lower surface of the optical waveguide layer 4312. According to an embodiment, the refractive indices of the protruding area 4312a and the concave area 4312b may be determined according to the curvature and/or the protruding or the concave degree of the curved surfaces.

According to various embodiments, the display panel 431 having a light diffusion structure through the above-described optical waveguide layer 4312 and light extraction part 4315 may generate an image blur. In order to improve same, the data of the first area A1 may be compensated through software by applying separate edge sharpening, so as to finally have a level of sharpness similar to the image of the second area A2. In some embodiments, the light emitted from the first area A1 may have a relatively high ratio of side light components. This may cause a blue shift in wavelength in the OLED display panel 431 having a micro cavity structure. In order to compensate for same, the pixels of the first area A1 and the second area A2 may be designed to emit light of different wavelengths. In some embodiments, in case that each of the areas A1 and A2 is identically designed, color difference therebetween may also be corrected through data processing for each of the areas.

According to various embodiments, an electronic apparatus (e.g., the electronic apparatus 300 in FIG. 5) may include a housing (e.g., the housing 110 in FIG. 1), a display (e.g., the display 400 in FIG. 5) disposed to be visible from the outside in an inner space (e.g., the inner space 3001 in FIG. 5) of the housing and including a display panel (e.g., the display panel 431 in FIG. 5), and a camera module (e.g., the camera module 500 in FIG. 5) disposed below the display, wherein the display panel includes a substrate (e.g., the substrate 4311 in FIG. 7), first multiple pixels (e.g., the pixels P in FIG. 7) arranged to have a first arrangement density in a first area (e.g., the first area A1 in FIG. 7) of the substrate, which is overlapped with an effective aperture of the camera module, when the display is seen from above, second multiple pixels (e.g., the pixels P in FIG. 7) arranged to overlap a second area (e.g., the second area A2 in FIG. 7) other than the first area of the substrate and have a second arrangement density higher than the first arrangement density, when the display is seen from above, a light-emitting part (e.g., the light-emitting part E in FIG. 7) disposed at a position corresponding to the first multiple pixels and the second multiple pixels, an optical waveguide layer (e.g., the optical waveguide layer 4312 in FIG. 7) disposed above the first multiple pixels and the second multiple pixels, and a light extraction part (e.g., the light extraction part 4315 in FIG. 7) disposed on the optical waveguide layer, in at least a part of a first sub-area (e.g., the first sub-area SA1 in FIG. 7) of the first area, which is at least partially overlapped with the space between the first multiple pixels, when the display is seen from above, and wherein at least a part of the light generated from the light-emitting part may be diffused to the first sub-area through the optical waveguide layer and be emitted to the outside through the light extraction part.

According to various embodiments, the optical waveguide layer may be formed to have a refractive index allowing light incident at a designated angle from the light-emitting part to be totally reflected.

According to various embodiments, a first buffer layer disposed between the substrate and the optical waveguide layer and a second buffer layer disposed on the optical waveguide layer may be included therein, and the optical waveguide layer may be formed to have a refractive index allowing light incident at a designated angle from the light-emitting part to be totally reflected through the first buffer layer and the second buffer layer which have a designated refractive index.

According to various embodiments, the first buffer layer and/or the second buffer layer may include a layer in which at least one inorganic film of a silicon nitride layer, a silicon oxy nitride layer, a silicon oxide layer, a titanium oxide layer, or an aluminum oxide layer is alternately laminated.

According to various embodiments, the light extraction part may be disposed to have a designated width along the edge of the first sub-area when the display is seen from above.

According to various embodiments, the optical waveguide layer may include a total reflection section disposed between an area overlapping the light-emitting part and an area overlapping the light extraction part at a designated length when the display is seen from above.

According to various embodiments, the light extraction part may be laminated on the optical waveguide layer.

According to various embodiments, the light extraction part may include a pattern formed on the outer surface of the optical waveguide layer and having a designated shape.

According to various embodiments, when the display is seen from above, in an area at least partially overlapping the light-emitting part, a light injection part disposed between the light-emitting part and the optical waveguide layer may be included therein.

According to various embodiments, a buffer layer disposed between the substrate and the optical waveguide layer may be included therein, and the light injection part may be disposed in the buffer layer.

According to various embodiments, the light injection part may include a pattern formed on the outer surface of the optical waveguide layer.

According to various embodiments, the light injection part may be formed to have a refractive index smaller than a refractive index of the light extraction part.

According to various embodiments, a refractive index of the light injection part may be determined according to an amount of light emitted to the light extraction part.

According to various embodiments, the light injection part may be configured to overlap at least a part of a second sub-area of the first area, which is overlapped with the first multiple pixels, when the display is seen from above.

According to various embodiments, an additional light injection part disposed to have a designated width in the second area at a boundary portion between the first area and the second area may be further included therein.

According to various embodiments, the display may further include at least one subsidiary material layer laminated on the rear surface of the display panel.

According to various embodiments, the at least one subsidiary material layer may further include at least one polymer layer disposed on the rear surface of the display panel and a functional member layer disposed below the at least one polymer layer, and the camera module may correspond to the display panel through an opening formed through the at least one polymer layer and the functional member layer.

According to various embodiments, a display panel may include a substrate, first multiple pixels arranged to have a first arrangement density in a first area of the substrate, second multiple pixels arranged to overlap a second area other than the first area of the substrate and have a second arrangement density higher than the first arrangement density, when the display is seen from above, a light-emitting part disposed at a position corresponding to the first multiple pixels and the second multiple pixels, an optical waveguide layer disposed above the first multiple pixels and the second multiple pixels, and a light extraction part disposed on the optical waveguide layer, in at least a part of a first sub-area of the first area, which is at least partially overlapped with the space between the first multiple pixels, when the display is seen from above, wherein at least a part of the light generated from the light-emitting part may be diffused to the first sub-area through the optical waveguide layer and be emitted to the outside through the light extraction part.

According to various embodiments, the first area may be an area overlapping an effective aperture of a camera module disposed under the display panel when the display panel is seen from above.

According to various embodiments, when the display is seen from above, a light injection part formed to overlap at least a part of the second sub-area of the first area, which is overlapped with the first multiple pixels, may be further included therein, and a refractive index of the light injection part may be determined according to an amount of light delivered through the optical waveguide layer and be emitted through the light extraction part.

Embodiments of the disclosure disclosed in the specification and the drawings are merely specific examples presented to easily describe the technical content according to the embodiments of the disclosure and to help understanding of the embodiments of the disclosure, and are not intended to limit the scope of embodiments of the disclosure. Accordingly, in connection with the scope of various embodiments of the disclosure, it should be interpreted that not only embodiments disclosed herein but also all changed or modified forms derived based on the technical idea of various embodiments of the disclosure are included in the scope of various embodiments of the disclosure.

## Claims

1. An electronic apparatus comprising:
a housing (110);
a display (400) disposed to be visible from the outside in an inner space (3001) of the housing (110) and comprising a display panel (431); and
a camera module (500) disposed below the display (400),
wherein the display panel (431) comprises:
a substrate (4311);
first multiple pixels (P) arranged to have a first arrangement density in a first area (A1) of the substrate (4311), which is overlapped with an effective aperture of the camera module, when the display (431) is seen from above;
second multiple pixels (P) arranged to overlap a second area (A2) other than the first area (A1) of the substrate (4311) and have a second arrangement density higher than the first arrangement density, when the display (431) is seen from above;
a light-emitting part (E) disposed at a position corresponding to the first multiple pixels and the second multiple pixels;
an optical waveguide layer (4312) disposed above the first multiple pixels and the second multiple pixels; and
a light extraction part (4315) disposed on the optical waveguide layer (4312) in at least a part of a first sub-area (SA1) of the first area (A1), which is at least partially overlapped with a space between the first multiple pixels, when the display is seen from above, and
wherein at least a part of the light generated from the light-emitting part (E) is diffused to the first sub-area (SA1) through the optical waveguide layer (4312) and emitted to the outside through the light extraction part (4315).

2. The electronic apparatus of claim 1, wherein the optical waveguide layer (4312) is formed to have a refractive index allowing light incident at a designated angle from the light-emitting part (E) to be totally reflected.

3. The electronic apparatus of claim 1, further comprising:
a first buffer layer (4313) disposed between the substrate (4311) and the optical waveguide layer (4312); and
a second buffer layer (4314) disposed on the optical waveguide layer (4312),
wherein the optical waveguide layer (4312) is formed to have a refractive index allowing light incident at a designated angle from the light-emitting part (E) to be totally reflected through the first buffer layer (4313) and the second buffer layer (4314) which have a designated refractive index.

4. The electronic apparatus of claim 3, wherein the first buffer layer (4313) and/or the second buffer layer (4314) comprises a layer in which at least one inorganic film of a silicon nitride layer, a silicon oxy nitride layer, a silicon oxide layer, a titanium oxide layer, or an aluminum oxide layer is alternately laminated.

5. The electronic apparatus of claim 1, wherein the light extraction part (4315) is disposed to have a designated width along the edge of the first sub-area (SA1) when the display (400) is seen from above.

6. The electronic apparatus of claim 1, wherein the optical waveguide layer (4312) comprises a total reflection section disposed between an area overlapping the light-emitting part (E) and an area overlapping the light extraction part (4315) at a designated length when the display (400) is seen from above.

7. The electronic apparatus of claim 1, wherein the light extraction part (4315) is laminated on the optical waveguide layer (4312).

8. The electronic apparatus of claim 1, wherein the light extraction part (4315) comprises a pattern which is formed on the outer surface of the optical waveguide layer (4312) and has a designated shape.

9. The electronic apparatus of claim 1, further comprising a light injection part (4316) disposed between the light-emitting part (E) and the optical waveguide layer (4312) in an area at least partially overlapping the light-emitting part (E) when the display (400) is seen from above.

10. The electronic apparatus of claim 9, further comprising a buffer layer (4313) disposed between the substrate (4311) and the optical waveguide layer (4312),
wherein the light injection part (4316) is disposed in the buffer layer (4313).

11. The electronic apparatus of claim 9, wherein the light injection part (4316) comprises a pattern formed on the outer surface of the optical waveguide layer (4312).

12. The electronic apparatus of claim 9, wherein the light injection part (4316) is formed to have a refractive index smaller than a refractive index of the light extraction part (4315).

13. The electronic apparatus of claim 9, wherein a refractive index of the light injection part (4316) is determined according to an amount of light emitted to the light extraction part (4315).

14. The electronic apparatus of claim 9, wherein the light injection part (4316) is configured to overlap at least a part of a second sub-area (SA2) of the first area (A1), which is overlapped with the first multiple pixels, when the display (400) is seen from above.

15. The electronic apparatus of claim 1, further comprising an additional light injection part (4316) disposed to have a designated width in the second area (A2), at a boundary portion between the first area (A1) and the second area (A2).
